Europäisches Patentamt

European Patent Office

Office européen des brevets

(11) Numéro de publication: **0 227 498**
**A1**

## (12) DEMANDE DE BREVET EUROPEEN

(21) Numéro de dépôt: **86402278.5**

(22) Date de dépôt: **14.10.86**

(51) Int. Cl.⁴: **G 01 R 15/00**
**H 01 R 9/24**

(30) Priorité: **04.11.85 FR 8516276**

(43) Date de publication de la demande:
**01.07.87 Bulletin 87/27**

(84) Etats contractants désignés:
**AT BE CH DE ES FR GB IT LI NL**

(71) Demandeur: **HAGER ELECTRO S.A.**
**Boulevard d'Europe**
**F-67210 Obernai (FR)**

(72) Inventeur: **Bobin, Daniel**
**Rue de la Pierre-Fontaine**
**F-67210 Obernai (FR)**

**Rolatti, Jean-Marie**
**8 rue d'Obernai**
**F-67230 Benfeld (FR)**

(74) Mandataire: **Lemoine, Michel et al**
**Cabinet Michel Lemoine 13 Boulevard des Batignolles**
**F-75008 Paris (FR)**

(54) **Dispositif de mesure centralisée pour installations électriques.**

㉗ Le dispositif de mesure centralisée comporte un boîtier isolant avec des passages (9) pour les conducteurs du réseau, ces passages étant entourés par des bobines de détection (6) centrées sur les passages et reliées à des bornes (10, 11) pour la mesure, le boîtier comportant, du côté opposé à l'extrémité du passage par laquelle pénètre le conducteur de réseau, des barrettes de distribution (16), avec une borne (17) recevant l'extrémité du conducteur de réseau, et des bornes de distribution (18).

Fig. 1

EP 0 227 498 A1

## Description

Dispositif de mesure centralisée pour installations électriques.

La présente invention a trait à un dispositif de mesure centralisée pour installations électriques telles que notamment les installations d'habitation.

L'intérêt de la mesure centralisée de l'intensité ou de la consommation de puissance dans des installations électriques, et notamment dans les locaux d'habitation, s'accroît continuellement. En effet, une telle mesure ne permet pas seulement de contrôler le fonctionnement de l'installation lors de la mise en marche de certains équipements ou appareils électriques, mais encore de commander des dispositifs de délestage, de répartition ou régulation permettant de maintenir, à tout moment, la puissance totale consommée au-dessous d'une certaine valeur et, par conséquent, de bénéficier de conditions d'abonnement plus favorables auprès du réseau électrique. En outre, l'obtention d'une information instantanée par la mesure centralisée laisse envisager la possibilité d'une protection des installations électriques et du réseau, à l'aide d'appareils de protection simplifiés, sans utiliser des moyens complexes et onéreux tels que les disjoncteurs différentiels.

On sait déjà détecter des paramètres électriques d'un circuit d'alimentation, tels qu'intensité, voltage ou puissance consommée en entourant les conducteurs électriques de puissance de capteurs constitués par des bobines de forme torique générant un signal électrique recueilli sur un circuit de mesure approprié. Ainsi la demande de modèle d'utilité allemand G 84 26944.8 décrit un appareil de mesure muni de bagues conductrices entourant, chacune, l'un des conducteurs d'un système d'alimentation triphasé avec conducteur neutre et conducteur de terre, la bague traversant elle-même une bobine de fil électrique dont les extrémités sont reliées à un circuit de mesure utilisant notamment une carte de circuits imprimés, l'ensemble de ces différents éléments étant noyé dans un isolant.

Un tel dispositif est cependant complexe, coûteux et peu pratique. Sa mise en oeuvre est particulièrement délicate et nécessite l'utilisation de conducteurs particuliers pouvant être amenés à travers les passages formés par les bagues conductrices en question.

La présente invention se propose de remédier à ces inconvénients et de fournir un dispositif de mesure centralisé pour installations électriques, et notamment installations électriques de locaux d'habitation, simple peu coûteux, et susceptible d'être monté très rapidement.

L'invention a pour objet un dispositif de mesure centralisée pour installations électriques, caractérisé en ce qu'il comporte, en combinaison:
- un support isolant, par exemple sous forme d'un boîtier,
- un ou plusieurs passages, dans le support, pour les conducteurs en provenance du réseau d'alimentation,
- au moins un élément ou tore bobiné de détection entourant un ou plusieurs passages pour entourer un ou plusieurs conducteurs du réseau.

- des barrettes de distribution disposées sur le support à l'extrémité du passage opposée à celle par laquelle pénètre le conducteur de réseau, chaque barrette présentant une borne recevant l'extrémité du conducteur de réseau correspondant et une ou plusieurs bornes de distribution pour des départs de conducteurs de distribution de l'installation,
- et une pluralité de bornes portées par le support, de préférence également du côté opposé aux extrémités de passage par lesquelles pénètrent les conducteurs de réseau, et électriquement reliées auxdits éléments ou tores bobinés pour la connexion de conducteurs d'exploitatation des signaux de mesure.

Le dispositif peut comprendre des tores bobinés individuels pour chaque conducteur et/ou des tores bobinés communs à plusieurs conducteurs, et notamment un seul tore traversé par la totalité des conducteurs de réseau afin de permettre une mesure différentielle.

Dans une forme de réalisation préférée, le boîtier, qui présente une forme généralement prismatique, est composé de deux parties susceptibles d'être assemblées, ces parties étant convenablement cloisonnées intérieurement pour pouvoir recevoir le ou les tores bobinés de mesure ainsi que les bornes de raccordement des conducteurs d'exploitation de mesure, alors que les barrettes sont, de préférence, disposées sur l'une des faces du boîtier, et à l'extérieur de celui-ci.

Dans le cas d'un dispositif présentant d'une part, dans le boîtier, une rangée de tores bobinés individuels, à savoir un tore par conducteur de réseau, par exemple pour des mesures d'intensité, et un élément ou tore commun à plusieurs ou à la totalité des conducteurs de réseau, par exemple pour la mesure différentielle, l'épaisseur du boîtier se trouve accrue, les tores individuels, d'une part, et le tore pour la mesure différentielle, d'autre part, étant successivement alignés dans la direction des conducteurs de réseau.

Les bornes pour les conducteurs d'exploitation de mesure peuvent permettre l'introduction des extrémités de ces conducteurs du côté du support présenté par les barrettes et/ou du côté opposé et/ou par une face du support perpendiculaire auxdits côtés, les conducteurs arrivant alors dans un plan perpendiculaire à la direction des conducteurs de réseau.

D'autres avantages et caractéristiques de l'invention apparaîtront à la lecture de la description suivante, faite à titre d'exemple non limitatif, et se référant au dessin annexé dans lequel:

la figure 1 représente une vue en élévation d'un dispositif selon une première forme de réalisation, avec une coupe partielle,

la figure 2 représente une vue de dessus de ce dispositif,

la figure 3 représente une vue en coupe transversale de ce dispositif,

la figure 4 représente une vue en élévation d'un dispositif selon une variante de l'invention, une des parties du boîtier étant ôtée,

la figure 5 représente une vue de dessus de ce dispositif, avec une coupe partielle,

la figure 6 représente une vue en coupe transversale de ce dispositif.

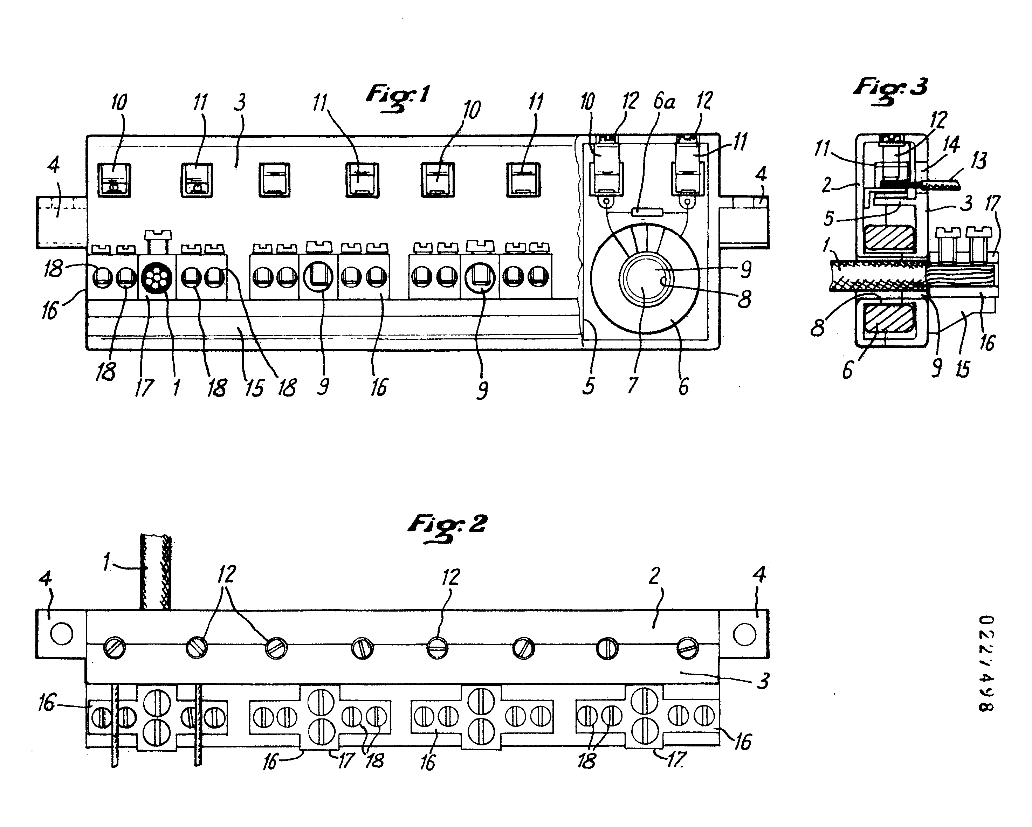

On se réfère tout d'abord aux figures 1 à 3.

Le dispositif représenté est destiné à la mesure centralisée et est prévu pour être placé à l'endroit d'arrivée des quatre conducteurs 1 d'un réseau triphasé + neutre d'alimentation.

Le dispositif comporte un boîtier de forme générale rectangulaire formé de deux parties 2, 3 avec des oreilles de fixation 4. Lorsque les deux parties 2 et 3 sont réunies, le boîtier présente un espace interne muni de cloisons 5 délimitant, dans le boîtier, quatre volumes divisés chaque fois en deux. Dans la partie inférieure de chaque volume se trouve logé un tore bobiné 6 dont l'ouverture 7 est traversée et centrée par une paroi ε du boîtier délimitant un passage 9 susceptible d'être traversé, comme on le voit sur les figures 1 et 3, par un conducteur de réseau 1. Le boîtier comporte ainsi quatre passages 9, à savoir un pour chaque conducteur 1. A la partie supérieure du volume correspondant à l'un des tores 6, se trouvent logées deux bornes 10, 11 munies de vis 12 permettant le serrage des extrémités dénudées de conducteurs 13 destinés à l'exploitation des signaux de mesure, ces conducteurs 13 traversant un orifice 14 pratiqué dans la partie 3 du boîtier. Les vis 12 présentent des têtes qui sont accessibles, par des trous correspondants, depuis la tranche supérieure du boîtier. Les bornes 10, 11 sont reliées aux deux extrémités du tore 6 comme on le voit sur la figure 1.

La face inférieure de la partie 3 de boîtier présente, d'un seul tenant, une console 15 qui supporte un ensemble de quatre barrettes de distribution 16, chaque barrette présentant un plot ou borne centrale 17 avec ses vis correspondantes et, de part et d'autre de la borne centrale, deux bornes latérales 18. La borne centrale 17 reçoit, comme on le voit bien sur la figure 3, l'extrémité dénudée du conducteur de réseau 1 après que celui-ci a traversé le passage 9 et la bobine 6. Les bornes 18 reçoivent les extrémités des conducteurs de distribution électrique du local ou d'un coffret de distribution.

A chaque tore bobiné 6 se trouve associée une résistance de charge 6a ajustable permettant un ajustement pour l'obtention d'un signal de mesure cohérent sur chacun des capteurs formés par les tores bobinés 6.

Le dispositif selon l'invention peut être très facilement posé à l'endroit où aboutissent les extrémités des conducteurs d'alimentation du réseau. Après avoir dénudé ces conducteurs, on les fait passer à travers les passages correspondants 9 et on les fixe dans leurs bornes 17, après quoi on relie aux bornes 18 les différents conducteurs de distribution, alors que les bornes 10 et 11 reçoivent les extrémités des conducteurs destinés à exploiter les signaux de mesure générés dans les tores 6, tels que, notamment, la mesure d'intensité propre à chacun des conducteurs 1.

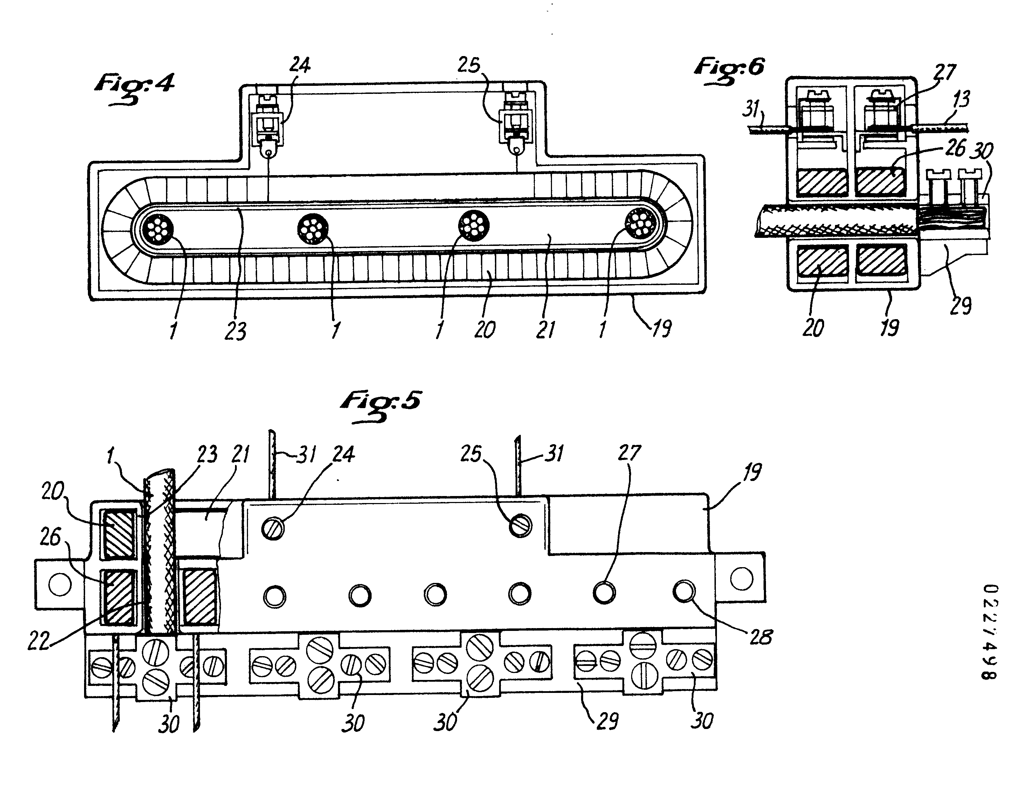

On se réfère maintenant aux figures 4, 5 et 6.

Dans cette forme de réalisation, le boîtier 19 présente une épaisseur plus grande. Le boîtier peut recevoir, d'une part, un élément bobiné aplati oblong 20 entourant la totalité des quatre conducteurs 1 lorsque ceux-ci sont amenés à travers le boîtier. De préférence, du côté de l'élément 20, le boîtier présente, à cette fin, un passage 21 allongé de grande dimension formé par la paroi de boîtier 23 autour de laquelle est enroulé l'élément 20. Les extrémités de l'élément aboutissent à deux bornes d'exploitation 24, 25 situées à la partie supérieure du boîtier et accessibles par sa face postérieure, c'est-à-dire la face présentant le passage allongé 21. Il est ainsi possible de recevoir sur les conducteurs 31 reliés aux bornes 24, 25, les signaux de mesure différentielle centralisée que l'on souhaite.

Le passage 21 débouche dans quatre passages 22 analogues aux passages 9 et qui le prolongent. Ces passages 22 traversent et centrent quatre tores bobinés 26 analogues ou identiques aux tores individuels 6, ces tores 26 possédant des extrémités reliées à des bornes 27, 28 analogues aux bornes 11, 12. Ces bornes 27, 28 permettent de recevoir, par la face opposée à celle par laquelle arrivent les conducteurs 1, les conducteurs 13 d'exploitation de mesure, notamment d'intensité individuelle de chaque conducteur. Enfin la face correspondante du boîtier porte également une console 29, analogue à la console 15 et recevant des barrettes 30 en tout point identiques aux barrettes 16.

Ce dispositif est également très simple à mettre en oeuvre et, de ce point de vue, s'apparente au dispositif représenté sur les figures 1 à 3 avec simplement, en plus, la possibilité d'utiliser les bornes 24, 25 pour la mesure différentielle.

Bien que l'invention ait été décrite à propos d'une forme de réalisation particulière, il est bien entendu qu'elle n'y est nullement limitée et qu'on peut lui apporter diverses modifications de formes ou de matériaux sans pour cela s'éloigner ni de son cadre ni de son esprit. Ainsi, par exemple, les tores bobinés pourraient avoir une forme qui ne soit pas réellement torique pour forme des éléments de mesure bobinés comportant un noyau continu ayant une autre forme que celle d'un tore géométrique.

**Revendications**

1) Dispositif de mesure centralisée pour installations électriques, caractérisé en ce qu'il comporte, en combinaison:
- un support isolant, notamment un boîtier (2,3),
- un ou plusieurs passages (9, 21, 22), dans le support, pour les conducteurs (1) en provenance du réseau d'alimentation,
- au moins un tore ou élément bobiné de détection (6, 20, 26) entourant un plusieurs passages (9, 21, 22) pour entourer un ou plusieurs conducteurs (1) du réseau,
- des barrettes de distribution (16, 30) disposées sur le support à l'extrémité du passage opposée à celle par laquelle pénètre le conducteur (1) de réseau, chaque barrette présentant une borne (17) recevant l'extrémité du conducteur de réseau correspondant et une ou plusieurs bornes de distribution (18) pour les départs de conducteurs de l'installation,
- et une pluralité de bornes (10, 11, 24, 25, 27 et 28) reliées au ou auxdits tores bobinés pour la connexion de conducteurs d'exploitation des signaux de mesure d'intensité et/ou de mesure différentielle.

2) Dispositif selon la revendication 1, caractérisé en ce qu'il comporte, pour chaque conducteur de réseau, un tore bobiné (6) attribué à ce conducteur.

3) Dispositif selon l'une des revendications 1 et 2, caractérisé en ce qu'il comporte un élément bobiné (20) entourant la totalité des conducteurs.

4) Dispositif selon l'une quelconque des revendications 1 à 3, caractérisé en ce que le boîtier présente une forme générale prismatique et est composé de deux parties (2, 3) susceptibles d'être assemblées, lesdites parties étant cloisonnées intérieurement pour recevoir le ou les éléments bobinés ainsi que les bornes de raccordement des conducteurs d'exploitation de mesure, les barrettes étant disposées sur l'une des faces du boîtier et à l'extérieur de celui-ci.

5) Dispositif selon l'une quelconque des revendications 1 à 4, caractérisé en ce que chaque élément bobiné (6, 20, 26) est traversé et centré par une paroi de boîtier formant un passage.

6) Dispositif selon l'une quelconque des revendications 1 à 5, caractérisé en ce que les bornes (10, 11, 24, 25) reliées aux éléments bobinés, pour la connexion de conducteurs d'exploitation de signaux de mesure, sont disposées dans le boîtier.

Fig.1

Fig.2

Fig.3

0227498

Fig.6

Fig.4

Fig.5

Office européen
des brevets

# RAPPORT DE RECHERCHE EUROPEENNE

Numero de la demande

EP 86 40 2278

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 996 513 (F.C. BUTLER)<br>* Résumé; colonne 2, lignes 17-50; figures 1-2 * | 1,3,6 | G 01 R   15/00<br>H 01 R    9/24 |
| | --- | | |
| A | FR-A- 970 379 (M. FERRARIO et al.) | | |
| | --- | | |
| A | ELEKTROTECHNISCHE ZEITSCHRIFT, édition A, vol. 74, no. 23, décembre 1953, page XIII, Berlin, DE;<br>"AEG-Zwergstromwandler Reihe 0,5"<br>* Figures 1-3 * | 2 | |
| | ----- | | |

### DOMAINES TECHNIQUES RECHERCHES (Int. Cl.4)

G 01 R
H 01 F
H 01 R

Le présent rapport de recherche a été établi pour toutes les revendications

| Lieu de la recherche | Date d'achèvement de la recherche | Examinateur |
|---|---|---|
| LA HAYE | 24-02-1987 | KUSCHBERT D.E. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82